# EUROPÄISCHE PATENTSCHRIFT

(11) **EP 1 879 294 B1**
(45) Veröffentlichungstag und Bekanntmachung des Hinweises auf die Patenterteilung: **10.03.2010**
(21) Anmeldenummer: 06116945.4
(22) Anmeldetag: 11.07.2006
(51) Int. Cl.: H03K 17/95, G01D 11/24, H05K 5/06, H05K 3/28

(54) **Elektrisches Gerät und Verfahren zur Herstellung eines elektrischen Geräts**
Electrical device and method of producing an electrical device
Appareil électrique et méthode de fabrication d'un appareil électrique

(43) Veröffentlichungstag der Anmeldung: 16.01.2008
(73) Patentinhaber: BALLUFF GmbH, 73765 Neuhausen (DE)
(72) Erfinder: Jagiella, Manfred, Dr., 73274 Notzingen (DE); Fritton, Michael, 73249 Wemau (DE)
(74) Vertreter: Hoeger, Stellrecht & Partner Patentanwälte

(56) Entgegenhaltungen:
- EP-A2- 0 650 315
- WO-A-98/37742
- DE-A1- 10 013 218
- DE-A1- 19 504 608

## Beschreibung

Die Erfindung betrifft ein elektrisches Gerät, umfassend ein Gehäuse, mindestens einen Schaltungsträger mit einer elektrischen Schaltung, welcher in dem Gehäuse positioniert ist, wobei in einem Innenraum des Gehäuses eine Formmasse angeordnet ist, und eine Abdeckungseinrichtung, welche zwischen der elektrischen Schaltung oder einem Teil der elektrischen Schaltung und der Formmasse angeordnet ist und welche aus einem zusammenhängenden Fertigmaterial hergestellt ist und kompressibel ist, und durch welche Kräfte aufnehmbar sind, die in Richtung der elektrischen Schaltung wirken.

Die Erfindung betrifft ferner ein Verfahren zur Herstellung eines elektrischen Geräts, bei dem mindestens ein Schaltungsträger mit einer elektrischen Schaltung in einem Gehäuse positioniert wird und das Gehäuse mit Formmasse befüllt wird, wobei an dem mindestens einen Schaltungsträger eine Abdeckungseinrichtung aus einem Fertigmaterial positioniert wird, welche kompressibel ist und durch welche Kräfte aufnehmbar sind, die in Richtung der elektrischen Schaltung wirken.

Ein Beispiel für eine Formmasse ist ein aushärtbares Kunstharz (Gießharz). Mit der Formmasse lässt sich die elektrische Schaltung ummanteln, um sie vor in das Gehäuse eindringenden Medien wie beispielsweise Kühlmedium, Schmiermedium oder auch vor Bearbeitungsabfällen und dergleichen zu schützen.

Aus der WO 98/37742 ist ein Verfahren zur Bereitstellung einer Harzdeckschicht auf einer gedruckten Schaltung bekannt, wobei die gedruckte Schaltung einen gedruckten Schaltungsträger umfasst, welcher mindestens eine elektrische Komponente aufweist, und wobei die Deckschicht variierende mechanische Eigenschaften in der Richtung von rechten Winkeln zu der Deckschicht aufweist. Die Deckschicht wird durch Spritzguss auf einem schaumbildenden reaktiven Spritzgussmaterial hergestellt.

Aus der DE 195 04 608 A1 ist als Beispiel eines elektrischen Geräts ein Positionssensor bekannt, welcher eine auf einem Träger angeordnete elektrische Schaltung umfasst, welche mit einem elektrischen Anschlusselement und mit einem Sensorelement verbunden ist, und ein Gehäuse mit einem Innenraum zur Aufnahme des Trägers mit der elektrischen Schaltung umfasst, welches eine Öffnung für das Anschlusselement und eine Öffnung für das Sensorelement aufweist. Zwischenräume zwischen dem Gehäuse, dem Träger und der elektrischen Schaltung sowie Zwischenräume zwischen dem Gehäuse und dem Anschlusselement und Zwischenräume zwischen dem Gehäuse und dem Sensorelement sind mit einer Duroplast-Formmasse ausgefüllt.

Aus der DE 100 13 218 A1 ist ein Positionssensor mit einem Gehäuse zur Aufnahme eines auf einem Träger angeordneten elektrischen Schaltkreises in einem Gehäuseinnenraum und einem elektrischen Anschlusselement bekannt. Der Träger und das Anschlusselement sind zu einer Träger-Anschlusselement-Kombination starr miteinander verbunden und in einem Zwischenraum zwischen der Träger-Anschlusselement-Kombination und einer Gehäuseinnenwand ist eine Formmasse angeordnet.

Der Erfindung liegt die Aufgabe zugrunde, ein elektrisches Gerät der eingangs genannten Art bereitzustellen, welcher bei einfacher Herstellbarkeit sicher funktioniert.

Diese Aufgabe wird bei dem eingangs genannten elektrischen Gerät erfindungsgemäß dadurch gelöst, dass die Abdeckungseinrichtung als Schlauch ausgebildet ist und dass die Abdeckungseinrichtung so elastisch ausgebildet ist, dass sie bei der Herstellung des elektrischen Geräts über den mindestens einen Schaltungsträger mit der elektrischen Schaltung ziehbar ist und an diesem nach dem Überziehen anliegt.

Zur Herstellung eines eingangs genannten elektrischen Geräts muss das Gehäuse mit fließfähiger Formmasse befüllt werden, die dann aushärtet. Bei der Befüllung und/oder beim Aushärten können auf die elektrische Schaltung Kräfte ausgeübt werden, die zu einer Zerstörung von elektrischen Schaltungselementen oder zu Unterbrechungen von Kontaktstellen (wie Lötstellen) führen können.

Durch die kompressible Abdeckungseinrichtung können Kräfte, welche insbesondere durch die Formmasse verursacht sind und sonst auf die elektrische Schaltung wirken würden, abgefangen werden. Dadurch wird die elektrische Schaltung geschützt und ein Sensor lässt sich mit höherer Ausfallsicherheit herstellen.

Es kann auch bei dem Betrieb eines fertig hergestellten elektrischen Geräts das Problem auftreten, dass aufgrund unterschiedlicher Wärmedehnungskoeffizienten zwischen Formmasse und Schaltungselementen der elektrischen Schaltung eine Kraft in Richtung der elektrischen Schaltung ausgeübt wird. Auch solche Kräfte lassen sich durch die Abdeckungseinrichtung, welche kompressibel ist, auffangen und von der elektrischen Schaltung abhalten bzw. betragsmäßig stark reduzieren.

Die Abdeckungseinrichtung lässt sich auf einfache Weise herstellen. Es muss keine Beschichtung der elektrischen Schaltung vorgesehen werden, sondern die Abdeckungseinrichtung wird aus einem zusammenhängenden Fertigmaterial in Schlauchform an dem Schaltungsträger hergestellt.

Die Herstellung des elektrischen Geräts lässt sich auch kostengünstiger durchführen. Wenn die Abdeckungseinrichtung an dem Schaltungsträger mit der elektrischen Schaltung angeordnet ist, dann lässt sich dieser testen. Wenn ein Defekt festgestellt wird, dann lässt sich die Abdeckeinrichtung, welche aus einem zusammenhängenden Fertigmaterial hergestellt ist, abnehmen und die Schaltung lässt sich "reparieren", indem beispielsweise ein defektes Schaltungselement ausgetauscht wird. Bei aus dem Stand der Technik bekannten Verfahren, bei welchem auf den Schaltungsträger mit der elektrischen Schaltung eine flüssig zu verarbeitende Masse in der Art eines Lacks aufgetragen wird, ist eine Reparatur nach dem Testen nicht möglich. Wenn ein Defekt festgestellt wird, ist der gesamte Schaltungsträger irreparabel unbrauchbar.

Weiterhin hat man für die Herstellung auch eine kürzere Prozesszeit, da die Abdeckungseinrichtung aus dem Fertigmaterial nicht trocknen bzw. aushärten muss. Weiterhin hat man eine hohe Konstanz in den Eigenschaften der Abdeckungseinrichtung im Vergleich zu einem Lackierungsverfahren eines elektrischen Schaltungsträgers mit einer elektrischen Schaltung.

Die Abdeckungseinrichtung, welche aus einem Fertigmaterial hergestellt ist, ist insbesondere so ausgebildet, dass sie bei der Herstellung des elektrischen Geräts, nachdem sie an dem Schaltungsträger positioniert ist, von diesem abnehmbar ist.

Die Abdeckungseinrichtung ist als Schlauch ausgebildet. Ein solcher Schlauch lässt sich auf einfache Weise auf die gewünschte Länge ablängen. Die gewünschte Länge ist beispielsweise bestimmt durch den Abstand zwischen einem Sensorelement, welches an dem Schaltungsträger angeordnet ist, und einem elektrischen Anschlusselement, welches an dem Schaltungsträger angeordnet ist. Der Schlauch lässt sich auf den Schaltungsträger aufziehen.

Die Abdeckungseinrichtung ist so elastisch ausgebildet, dass sie bei der Herstellung des Sensors über den mindestens einen Schaltungsträger mit der elektrischen Schaltung ziehbar ist und an diesem nach dem Überziehen anliegt und sich dabei insbesondere an den Schaltungsträger und die elektrischen Schaltungselemente anschmiegt. Eine solche Abdeckungseinrichtung lässt sich auf einfache Weise an dem Schaltungsträger fixieren. Entsprechend lässt sich das herzustellende elektrische Gerät auf einfache Weise fertigen.

Insbesondere ist die Abdeckungseinrichtung so angeordnet und ausgebildet, dass während der Herstellung des elektrischen Geräts durch die Formmasse in Richtung der elektrischen Schaltung ausgeübte Kräfte aufnehmbar sind und/oder aufgrund unterschiedlicher Wärmedehnungskoeffizienten zwischen Formmasse und Schaltungselementen der elektrischen Schaltung oder des mindestens einen Schaltungsträgers verursachte Kräfte in Richtung der elektrischen Schaltung aufnehmbar sind. Dadurch lässt sich ein elektrisches Gerät mit geringer Ausschussquote herstellen bzw. es lässt sich ein elektrisches Gerät herstellen, welcher im Betrieb auch bei Temperaturschwankungen eine hohe Ausfallsicherheit aufweist.

Günstig ist es, wenn die Abdeckungseinrichtung mindestens an einem Teil der elektrischen Schaltung anliegt. Beispielsweise ist sie mindestens an einen Teil der elektrischen Schaltung angeschmiegt. Dadurch lassen sich auf sichere Weise Kräfte von der elektrischen Schaltung abfangen.

Aus dem gleichen Grund ist es günstig, wenn die Abdeckungseinrichtung mindestens an einem Teil des Schaltungsträgers anliegt. Dadurch lässt sich auch eine gute Fixierungsbasis für die Abdeckungseinrichtung bereitstellen.

Es ist ferner vorgesehen, dass die Formmasse an der Abdeckungseinrichtung anliegt oder an einer Zwischenlage anliegt, welche selber an der Abdeckungseinrichtung anliegt. Die Zwischenlage ist beispielsweise eine Isolierungshülle zur elektrischen Isolierung oder eine elektrische Abschirmungshülle. Durch die Anlage der Formmasse direkt an der Abdeckungseinrichtung oder vermittelt über die Zwischenlage kann die kompressible Abdeckungseinrichtung Kräfte aufnehmen und von der elektrischen Schaltung abhalten.

Für die Herstellung des elektrischen Geräts ist es vorteilhaft, wenn die Abdeckungseinrichtung aus einem Trockenmaterial hergestellt ist. Sie lässt sich dann auf einfache Weise an dem Schaltungsträger positionieren. Insbesondere muss keine Beschichtung der elektrischen Schaltung vorgesehen werden.

Aus dem gleichen Grund ist es günstig, wenn die Abdeckungseinrichtung als Ganzes bei der Herstellung des elektrischen Geräts handhabbar ist. Sie lässt sich dadurch auf einfache Weise an dem Schaltungsträger positionieren.

Beispielsweise ist die Abdeckungseinrichtung aus einem Bandmaterial hergestellt. Das Bandmaterial kann dabei offen sein oder geschlossen sein. Ein offenes Bandmaterial lässt sich beispielsweise an dem Schaltungsträger aufwickeln, um die Abdeckungseinrichtung zu realisieren. Ein geschlossenes Bandmaterial liegt beispielsweise in Schlauchform vor, wobei der entsprechende Schlauch auf den Schaltungsträger aufgezogen werden kann.

Bei einer Ausführungsform weisen die Abdeckungseinrichtung oder Teile davon eine Klebeseite auf. Dadurch lässt sich beispielsweise auf einfache Weise eine Abdeckungseinrichtung durch Wicklung an dem Schaltungsträger oder Ablage an dem Schaltungsträger herstellen, welche an diesem adhäsiv fixiert ist.

Günstig ist es, wenn die Abdeckungseinrichtung den mindestens einen Schaltungsträger mit der elektrischen Schaltung im Wesentlichen vollständig zu der Formmasse hin abdeckt. Dadurch ist der Schaltungsträger (welcher beispielsweise Leiterbahnen aufweist) und die elektrische Schaltung sicher gegenüber von der Formmasse verursachten Kräften geschützt.

Es kann vorgesehen sein, dass die Abdeckungseinrichtung den mindestens einen Schaltungsträger umgibt, um diesen sicher vor Kräften zu schützen, die durch die Formmasse verursacht sind.

Bei einer Ausführungsform ist die Abdeckungseinrichtung um den mindestens einen Schaltungsträger gewickelt.

Es ist grundsätzlich möglich, dass die Abdeckungseinrichtung mindestens eine Matte umfasst. Die Matte ist beispielsweise aus einem Schaumstoffmaterial hergestellt. Eine solche Matte kann an einer Oberseite oder Unterseite eines Schaltungsträgers (wie beispielsweise einer Platine) positioniert werden, und zwar derart, dass sie seitlich nicht über den Schaltungsträger hinausragt. Ein solcher Schaltungsträger mit daran positionierter Matte bzw. mit daran positionierten Matten weist Querabmessungen auf, die allein durch die Querabmessungen des Schaltungsträgers bestimmt sind. Er lässt sich dann auch in einem Gehäuse mit entsprechend geringen Innenquerabmessungen (die an den Schaltungsträger ohne Abdeckungseinrichtung angepasst sind) positionieren.

Insbesondere ist die mindestens eine Matte an einer Oberseite und/oder Unterseite des mindestens einen Schaltungsträgers angeordnet. Dadurch lassen sich elektrische Schaltungselemente, welche an dem Schaltungsträger sitzen, gegenüber der Formmasse abdecken.

Beispielsweise ist die mindestens eine Matte aufgeklebt. Sie lässt sich dadurch auf einfache Weise an dem Schaltungsträger mit den elektrischen Schaltungselementen positionieren und fixieren.

Günstig ist es, wenn die mindestens eine Matte nicht über eine Seitenfläche des Schaltungsträgers hinaussteht. Sie vergrößert dadurch nicht die Querabmessungen des Schaltungsträgers mit fixierter Abdeckungseinrichtung. Ein solcher Schaltungsträger lässt sich dann auch in Gehäuse mit Querabmessungen, die auf den Schaltungsträger optimiert sind, einschieben. Wenn eine Matte nicht über eine Seitenfläche des Schaltungsträgers geführt werden muss, dann kann diese auch dicker ausgebildet werden und damit mit einer höheren Kompressibilität versehen werden.

Es ist beispielsweise vorgesehen, dass die mindestens eine Matte eine oder mehrere Kontaktstellen überdeckt. Dadurch lassen sich auch die Kontaktstelle bzw. Kontaktstellen gegenüber von der Formmasse ausgehenden bzw. ausgeübten Kräfte schützen. Beispielsweise ist es vorgesehen, dass eine Matte eine Kontaktstelle bzw. mehrere Kontaktstellen von einem Sensorelement an den Schaltungsträger überdeckt. Beispielsweise ist dazu die Matte an einem Ende des Schaltungsträger "hochgeschlagen" und beispielsweise adhäsiv an einem Sensorelement, welches quer zum Schaltungsträger orientiert ist, fixiert.

Ganz besonders vorteilhaft ist es, wenn die Abdeckung mindestens teilweise aus einem Schaummaterial und insbesondere aus einem geschlossenporigen Schaummaterial hergestellt ist. Durch Gaseinschlüsse in einem solchen Schaummaterial wird eine hohe Kompressibilität bereitgestellt, so dass sich Kräfte sicher von elektrischen Schaltungselementen abfangen lassen. Ein solches Schaummaterial lässt sich auch auf einfache Weise handhaben. Es ist grundsätzlich auch möglich, dass das Schaummaterial eine hohe elektrische Durchschlagsfestigkeit aufweist, um so auch eine Isolierungshülle zur elektrischen Isolierung der elektrischen Schaltung bereitzustellen.

Insbesondere ist das Schaummaterial der elektrischen Schaltung zugewandt. Dadurch liegt ein mechanischer Kontakt zwischen dem Schaummaterial und der elektrischen Schaltung vor, so dass ein Kraftpuffer bereitgestellt ist, durch welchen Kräfte von der elektrischen Schaltung abfangbar sind.

Es hat sich als günstig erwiesen, wenn das Schaummaterial eine Dicke von mindestens 0,8 mm im nicht-komprimierten Zustand aufweist, um sicher Kräfte von der elektrischen Schaltung abfangen zu können.

Es kann vorgesehen sein, dass dem mindestens einen Schaltungsträger eine Isolierungshülle zur elektrischen Isolierung zugeordnet ist. Dadurch wird die Durchschlagsfestigkeit des elektrischen Geräts erhöht. Dadurch wiederum wird die Ausfallsicherheit des elektrischen Geräts erhöht. Die Isolierungshülle kann dabei durch die Abdeckungseinrichtung gebildet sein oder eine getrennte Einrichtung sein. Bei einer durch die Abdeckungseinrichtung gebildeten Isolierungshülle kann dabei wiederum ein komprimierbares Material der Isolierungshülle genügende Durchschlagsfestigkeit aufweisen oder es können eine oder mehrere getrennte Isolierungshüllenlagen an der Abdeckungseinrichtung vorgesehen sein.

Bei einer Ausführungsform umgibt die Isolierungshülle die Abdeckungseinrichtung. Eine solche Isolierungshülle ist beispielsweise als Schrumpfschlauch ausgebildet, welcher über die Abdeckungseinrichtung gezogen ist.

Ferner günstig ist es, wenn dem mindestens einen Schaltungsträger eine elektrische Abschirmungshülle zugeordnet ist. Die Abschirmungshülle dient dazu, die elektrische Schaltung gegenüber elektromagnetischen Wellen und insbesondere gegenüber EMV-Verunreinigungen abzuschirmen. Dadurch wird die Ausfallsicherheit bzw. Betriebssicherheit des elektrischen Geräts erhöht.

Bei einer Ausführungsform ist die Abdeckungseinrichtung mehrlagig ausgebildet mit mindestens einer Lage aus einem kompressiblen Material zur Kraftaufnahme. Die Abdeckungseinrichtung kann weitere Funktionslagen beispielsweise zur Erhöhung der Durchschlagsfestigkeit und/oder zur Ausbildung einer elektrischen Abschirmung umfassen.

Insbesondere ist eine innere Lage, welche der elektrischen Schaltung zugewandt ist, eine Lage aus kompressiblem Material. Das kompressible Material steht dabei in direktmechanischem Kontakt mit der elektrischen Schaltung, um diese optimiert zu schützen.

Ferner günstig ist es, wenn die Abdeckungseinrichtung mindestens eine elektrische Abschirmungslage aufweist. Dadurch lässt sich die elektrische Schaltung beispielsweise gegenüber EMV-Verunreinigungen schützen. Diese elektrische Abschirmung kann auf einfache Weise hergestellt werden, indem die Abdeckungseinrichtung mit integrierter Abschirmungslage an dem Schaltungsträger positioniert wird.

Insbesondere ist die elektrische Abschirmungslage zwischen Lagen aus kompressiblem Material angeordnet. Dadurch lässt sich eine korrekte Positionierung der Abschirmungslage in einem bestimmten Abstand zu dem Schaltungsträger erreichen. Insbesondere lässt sich dadurch ein Kontakt der Abschirmungslage mit der elektrischen Schaltung verhindern.

Es kann vorgesehen sein, dass die Abdeckungseinrichtung mindestens eine elektrische Isolierungslage aufweist. Dadurch lässt sich die Herstellung des elektrischen Geräts vereinfachen, da integral mit der Positionierung der Abdeckungseinrichtung auch die Isolierungshülle hergestellt wird. Beispielsweise lässt sich so auf kostengünstige Weise die Schutzklasse II2 erreichen.

Bei einer Ausführungsform, bei der das elektrische Gerät ein Sensor ist oder einen Sensor umfasst, ist mindestens ein Sensorelement mit dem mindestens einen Schaltungsträger verbunden. Ein entsprechendes elektrisches Gerät lässt sich auf einfache Weise herstellen, da die Kombination aus Sensorelement und Schaltungsträger als Ganzes handhabbar ist, wenn das Sensorelement mit dem Schaltungsträger mechanisch verbunden ist. Beispielsweise ist das elektrische Gerät als induktiver Sensor, kapazitiver Sensor, Ultraschallsensor, Mikrowellensensor oder optischer Sensor ausgebildet. Er kann beispielsweise auch als Drucksensor usw. ausgebildet sein. Entsprechend ist das mindestens eine Sensorelement ausgebildet.

Bei dem Sensorelement handelt es sich beispielsweise um ein induktives Sensorelement oder kapazitives Sensorelement. Es ist auch grundsätzlich möglich, dass es sich bei dem Sensorelement um ein Ultraschallsensorelement oder Mikrowellensensorelement usw. handelt.

Beispielsweise ist das mindestens eine Sensorelement an einem vorderen Ende des Gehäuses angeordnet. Durch das vordere Ende des Gehäuses ist eine wirksame Sensorfläche definiert.

Es kann vorgesehen sein, dass ein elektrisches Anschlusselement mit dem mindestens einen Schaltungsträger verbunden ist. Insbesondere ist das elektrische Anschlusselement mechanisch mit dem Schaltungsträger verbunden. Dadurch lässt sich die Kombination aus elektrischem Anschlusselement und Schaltungsträger als Ganzes während der Herstellung des elektrischen Geräts handhaben.

Beispielsweise ist ein elektrisches Anschlusselement an einem hinteren Ende des Gehäuses angeordnet. Es lässt sich dadurch in einem maximalen Abstand von einem vorderen Ende des Gehäuses (welches beispielsweise eine wirksame Sensorfläche definiert) positionieren.

Beispielsweise ist das elektrische Gerät als Näherungssensor oder Näherungsschalter oder Positionssensor oder Positionsschalter ausgebildet. Durch ein solches elektrisches Gerät lässt sich die Annäherung eines Gegenstands oder die Position eines Gegenstands analog und/oder digital (als Schaltschwelle) erfassen.

Beispielsweise ist der mindestens eine Schaltungsträger eine Platine. Eine solche Platine lässt sich mit elektrischen Schaltungselementen bestücken. An der Platine können Leiterbahnen angeordnet sein.

Der Erfindung liegt ferner die Aufgabe zugrunde, ein Verfahren der eingangs genannten Art bereitzustellen, mit welchem sich ein elektrisches Gerät auf einfache Weise mit hoher Ausfallsicherheit und Betriebssicherheit herstellen lässt.

Diese Aufgabe wird bei dem eingangs genannten Verfahren erfindungsgemäß dadurch gelöst, dass die Abdeckungseinrichtung als Schlauch über den mindestens einen Schaltungsträger gezogen wird.

Das erfindungsgemäße Verfahren weist die bereits Im Zusammenhang mit dem erfindungsgemäßen elektrischen Gerät erläuterten Vorteile auf.

Weitere vorteilhafte Ausführungsformen wurden ebenfalls bereits im Zusammenhang mit dem erfindungsgemäßen Sensor erläutert.

Günstigerweise ist die Abdeckungseinrichtung so ausgebildet, dass sie, nachdem sie an dem Schaltungsträger positioniert ist, wieder von diesem entfernbar ist. Durch die Herstellung der Abdeckungseinrichtung aus einem Fertigungsmaterial ist dies erreicht. Dadurch erhält man eine kurze Prozesszeit für die Herstellung des erfindungsgemäßen elektrischen Geräts, da für die Herstellung der Abdeckungseinrichtung keine Trocknungszeit benötigt wird. Ferner lässt sich eine elektrische Schaltung mit daran positionierter Abdeckungseinrichtung elektrisch testen und gegebenenfalls, wenn der Test ein Problem detektiert, reparieren: Die Abdeckungseinrichtung lässt sich wieder von dem Schaltungsträger ablösen.

Insbesondere wird die Abdeckungseinrichtung vor Positionierung des mindestens einen Schaltungsträgers in dem Gehäuse an diesem angeordnet. Dadurch ist eine leichte Zugänglichkeit des Schaltungsträgers zur Positionierung der Abdeckungseinrichtung gewährleistet.

Die Abdeckungseinrichtung wird als Schlauch über den mindestens einen Schaltungsträger gezogen.

Günstig ist es, wenn der Schaltungsträger mit positionierter Abdeckungseinrichtung getestet wird und insbesondere getestet wird, bevor die Befüllung des Gehäuses mit Formmasse erfolgt. Wenn das Testen einen Defekt ergibt, dann kann die Schaltung "repariert" werden. Dazu wird die Abdeckungseinrichtung abgenommen und der Fehler korrigiert, indem beispielsweise das fehlerhafte Schaltungselement ausgetauscht wird.

Die nachfolgende Beschreibung bevorzugter Ausführungsformen dient im Zusammenhang mit der Zeichnung der näheren Erläuterung der Erfindung. Es zeigen:
- Figur 1: eine Schnittansicht eines Ausführungsbeispiels eines erfindungsgemäßen elektrischen Geräts;
- Figur 2: eine Ansicht längs der Linie 2-2 des elektrischen Geräts gemäß Figur 1 ohne Formmasse und Gehäuse;
- Figur 3: ein weiteres Ausführungsbeispiel mit einem Schaltungsträger und daran fixierter Abdeckungseinrichtung (ohne Formmasse und Gehäuse) in einer Schnittansicht; und
- Figur 4: den Schaltungsträger gemäß Figur 3 in einer Längsschnittansicht.

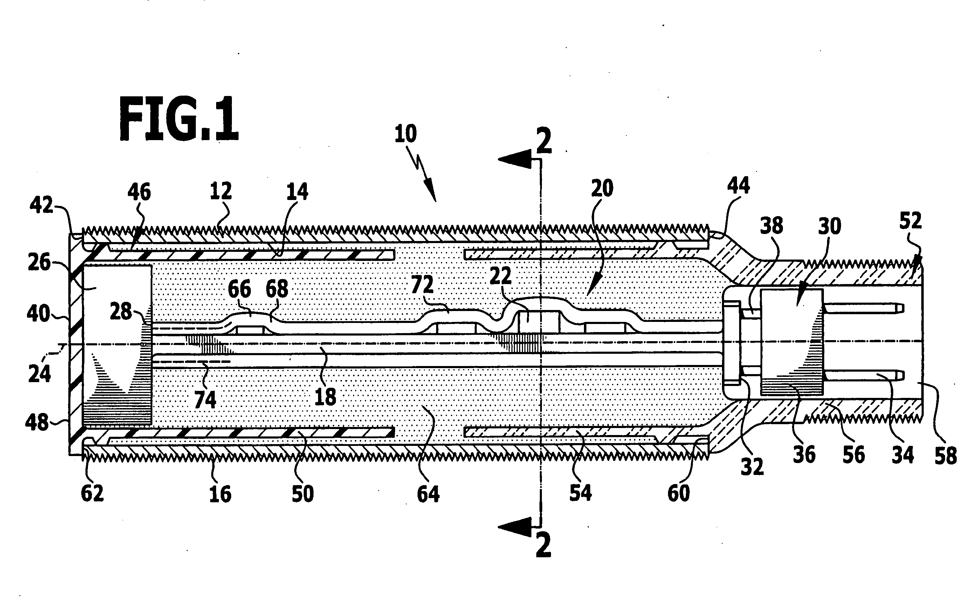

Ein Ausführungsbeispiel eines erfindungsgemäßen elektrischen Geräts, welches in Figur 1 mit 10 bezeichnet ist, umfasst ein Gehäuse 12. Das Gehäuse 12 umgibt einen Innenraum 14, welcher zur (geschützten) Aufnahme von Funktionsteilen des elektrischen Geräts dient. Das elektrische Gerät ist beispielsweise als Sensor ausgebildet.

Das Gehäuse 12 ist beispielsweise zylindrisch ausgebildet und der Innenraum 14 hat die Form eines (Hohl-)Zylinders. Andere Gehäuseformen sind möglich.

Bei dem in Figur 1 gezeigten Ausführungsbeispiel ist das Gehäuse 12 mit einem Außengewinde 16 versehen. Dieses Außengewinde 16 kann sich über eine Teillänge des Gehäuses 12 erstrecken oder über die Gesamtlänge.

Das Gehäuse 12 ist beispielsweise aus einem metallischen Material hergestellt.

In dem Gehäuse 12 ist (mindestens ein) Schaltungsträger 18 angeordnet. Dieser Schaltungsträger 18 ist beispielsweise als Platine oder bestückbare Folie oder als Flexprint-Träger ausgebildet. An dem Schaltungsträger 18 ist eine elektrische Schaltung 20 angeordnet, welche elektrische Schaltungselemente 22 aufweist. Bei diesen elektrischen Schaltungselementen 22 kann es sich um diskrete Schaltungselemente und/oder integrierte Schaltungselemente handeln. Ferner sind an dem Schaltungsträger 18 elektrische Verbindungen zwischen elektrischen Schaltungselementen 22 und weiteren Funktionsteilen (wie einem Sensorelement und einem elektrischen Anschlusselement) angeordnet. Diese elektrischen Verbindungen sind beispielsweise als Leiterbahnen an dem Schaltungsträger 18 gebildet.

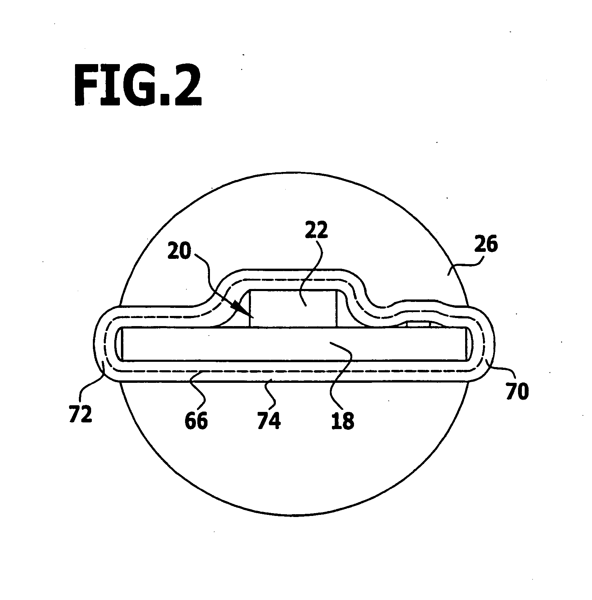

Das Gehäuse 12 weist eine Achse 24 auf. Die Achse 24 ist insbesondere eine Symmetrieachse des Innenraums 14. Bei dem gezeigten Ausführungsbeispiel ist der Schaltungsträger 16, welcher einen mindestens näherungsweise rechteckigen Querschnitt aufweist (Figur 2), an der Achse 24 angeordnet.

Das elektrische Gerät 10 weist ein Sensorelement 26 auf. Dieses Sensorelement 26 ist mit dem Schaltungsträger 18 elektrisch verbunden, um das Sensorelement 26 ansteuern zu können und Sensorsignale an die elektrische Schaltung 20 weitergeben zu können.

Es kann auch vorgesehen sein, dass das Sensorelement 26 mechanisch mit dem Schaltungsträger 18 verbunden ist. Beispielsweise ist das Sensorelement 26 an oder in der Nähe eines Endes 28 des Schaltungsträgers 18 mit diesem starr verbunden.

Ferner ist ein elektrisches Anschlusselement 30 elektrisch mit dem Schaltungsträger 18 verbunden, um der elektrischen Schaltung 20 extern Energie zuführen zu können und Sensorsignale extern abführen zu können.

Es kann auch vorgesehen sein, dass das elektrische Anschlusselement 30 mechanisch mit dem Schaltungsträger 18 verbunden ist. Insbesondere ist das elektrische Anschlusselement 30 an oder in der Nähe eines Endes 32 des Schaltungsträgers 18 mit diesem verbunden, wobei das Ende 32 dem Ende 28 gegenüberliegend ist.

Das elektrische Anschlusselement 30 umfasst beispielsweise eine Mehrzahl von Kontaktstiften 34, welche an einem Halteelement 36 gehalten sind. Von dem Halteelement 36 führen Verbindungsstifte 38 zu dem Schaltungsträger 18. Die Verbindungsstifte 38 sind beispielsweise an dem Schaltungsträger 18 angelötet.

Wenn das Sensorelement 26 und das elektrische Anschlusselement 30 mechanisch mit dem Schaltungsträger 18 verbunden sind, dann lässt sich diese Kombination als Einheit während der Herstellung des elektrischen Geräts 10 in das Gehäuse 12 einsetzen.

Bei dem elektrischen 10 handelt es sich beispielsweise um einen Näherungssensor oder Positionssensor, mit dem sich die Annäherung/Position eines Gegenstands (insbesondere metallischen Gegenstands) detektieren lässt. Es kann sich beispielsweise auch um einen Näherungsschalter oder Positionsschalter handeln, welcher ein Schaltsignal abgibt, sobald ein Gegenstand einen bestimmten Schwellenabstand zu einer aktiven Sensorfläche 40 bzw. Schwellenposition erreicht hat.

Bei dem Näherungs-/Positionssensor bzw. Näherungs-/Positionsschalter kann es sich beispielsweise um einen induktiven Näherungs-/Positionsschalter bzw. Näherungs-/Positionssensor oder um einen kapazitiven Näherungs-/Positionsschalter oder Näherungs-/Positionssensor handeln. Bei einem induktiven Näherungs-/Positionssensor umfasst das Sensorelement 26 eine oder mehrere Spulen als induktive Elemente sowie einen Spulenkern. Bei einem kapazitiven Näherungs-/Positionsschalter bzw. Näherungs-/Positionssensor umfasst das Sensorelement 26 ein oder mehrere kapazitive Elemente.

Das Sensorelement 26 ist an einem vorderen Ende 42 in dem Gehäuse 12 angeordnet. Das elektrische Anschlusselement 30 ist an einem hinteren Ende 44 des Gehäuses 12 angeordnet, wobei das hintere Ende 44 dem vorderen Ende 42 abgewandt ist. Das vordere Ende 42 des Gehäuses 12 definiert auch die aktive Sensorfläche 40.

Bei dem gezeigten Ausführungsbeispiel ist das Gehäuse 12 an dem vorderen Ende durch einen Einsatz 46 verschlossen, welcher einen Deckelbereich 48 und einen Eintauchbereich 50 aufweist. Der Eintauchbereich 50 ist in den Innenraum 14 des Gehäuses 12 eingetaucht. Er weist insbesondere eine Länge parallel zu der Achse 24 auf, welche größer ist als die entsprechende Länge des Sensorelements 26. Der Einsatz 46 ist beispielsweise aus einem Kunststoffmaterial hergestellt.

An dem hinteren Ende 44 des Gehäuses 12 ist ein Einsatz 52 angeordnet, welcher einen Eintauchbereich 54 aufweist. Über diesen Eintauchbereich 54 ist der Einsatz 52 in den Innenraum 14 des Gehäuses 12 eingetaucht.

Der Einsatz 52 umfasst ferner einen Anschlusselementbereich 56, welcher eine Öffnung 58 hat. Der Anschlusselementbereich 56 ragt über das Gehäuse 12 nach hinten hinaus. In dem Anschlusselementbereich 56 ist zumindest ein Teil des elektrischen Anschlusselements 30 angeordnet. Insbesondere ist das Halteelement 36 in der Öffnung 58 fixiert.

Der Anschlussbereich 56 weist eine insbesondere ringförmige Anlagefläche 60 auf, mit weicher er an eine Stirnseite des Gehäuses 12 am hinteren Ende 44 anlegbar ist.

Ebenso weist der Deckelbereich 48 des Einsatzes 46 eine insbesondere ringförmige Anlagefläche 62 auf, mit welcher er an eine Stirnseite des Gehäuses 12 an dessen vorderem Ende 42 anlegbar ist.

In dem Innenraum 14 des Gehäuses 12 ist zwischen der elektrischen Schaltung 20 und dem Gehäuse 12 eine Formmasse 64 angeordnet. Bei der Formmasse handelt es sich beispielsweise um ein ausgehärtetes Gießharz oder um einen Hartschaum. Während der Herstellung des Sensors 10 wird gießfähiges Gießharz (bzw. Hartschaum-Vormaterial) in das Gehäuse 12 gefüllt. Die Formmasse 64 dient zur Ummantelung des Schaltungsträgers 18 mit der elektrischen Schaltung 20, um die elektrische Schaltung 20 hermetisch abzuschließen. Sensoren als Beispiele für elektrische Geräte werden auch unter "schwierigen" Umweltbedingungen eingesetzt, wie beispielsweise in einer Werkzeugmaschine, wo sie Kühlmittel, Schmiermittel, Bearbeitungsabfällen und dergleichen ausgesetzt sein können. Solche Fluide oder Materialien können in das Gehäuse 12 eindringen und zu der elektrischen Schaltung 20 gelangen. Dadurch kann die Funktionsfähigkeit des Sensors 10 beeinträchtigt werden oder dieser kann ganz ausfallen. Die Formmasse 64 schützt die elektrische Schaltung 20.

Insbesondere sind die Zwischenräume zwischen der elektrischen Schaltung 20 und dem Gehäuse 12 in dem Innenraum 14 durch die Formmasse 64 ausgefüllt.

Erfindungsgemäß ist an dem Schaltungsträger 18 mit der elektrischen Schaltung 20 eine Abdeckungseinrichtung 66 angeordnet, welche an den Schaltungsträger 18 mit der elektrischen Schaltung 20 und den elektrischen Verbindungen angelegt ist. Diese Abdeckungseinrichtung 66 ist zwischen dem Schaltungsträger 18 mit der elektrischen Schaltung 20 und der Formmasse 64 positioniert. Die Abdeckungseinrichtung 66 ist dabei eine während der Herstellung des Sensors 10 als Ganzes handhabbare Einrichtung aus einem Fertigmaterial (insbesondere Trockenmaterial); die Abdeckungseinrichtung 66 ist insbesondere keine Beschichtung, welche auf der elektrischen Schaltung und dem Schaltungsträger 18 angeordnet ist, sondern eine separate Einrichtung, welche an dem Schaltungsträger 18 während der Herstellung des Sensors 10 positionierbar und fixierbar ist.

Die Abdeckungseinrichtung 66 umfasst mindestens eine Lage 68 aus einem komprimierbaren Material.

Bei dem komprimierbaren Material handelt es sich beispielsweise um ein geschlossenporiges Schaumstoffmaterial. Denkbare Materialien sind PU-Schaum oder Silikonschaum.

Vorzugsweise ist die Dicke der Lage 68 aus komprimierbarem Material mindestens 0,8 mm (im nicht-komprimierten Zustand).

Die Lage aus komprimierbarem Material 68 ist dem Schaltungsträger 18 mit der elektrischen Schaltung 20 zugewandt und schmiegt sich an diese an.

Während der Herstellung des elektrischen Geräts 10 können über die Formmasse 64 Kräfte auf die elektrische Schaltung 20 ausgeübt werden. Diese Kräfte können durch das Einbringen der auszuhärtenden Formmasse in das Gehäuse 12 verursacht sein oder auch durch die Aushärtung der Formmasse. Es besteht dabei die grundsätzliche Gefahr, dass Schaltungselemente der elektrischen Schaltung 20 zerstört werden können, was zu einem Ausfall des Sensors 10 führt.

Schaltungselemente der elektrischen Schaltung 20 weisen üblicherweise einen kleineren Wärmedehnungskoeffizienten als die (ausgehärtete) Formmasse 64 auf. Dies bedeutet, dass bei einer Temperaturerhöhung aufgrund dieser unterschiedlichen Wärmeausdehnung durch die Formmasse 64 verursachte Kräfte auf die elektrische Schaltung 20 ausgeübt werden, die wiederum zur Zerstörung von Schaltungselementen führen können.

Durch die erfindungsgemäße Abdeckungseinrichtung 66 mit der mindestens einen Lage 68 aus komprimierbarem Material können solche Kräfte, welche durch die Formmasse 64 verursacht sind, aufgefangen werden und von der elektrischen Schaltung 20 abgeschirmt werden bzw. zumindest betragsmäßig reduziert werden. Die Abdeckungseinrichtung 66 schützt damit die elektrische Schaltung 20 auf dem Schaltungsträger 18 vor durch die Formmasse 64 verursachten Kräften.

Bei einem Ausführungsbeispiel ist die Abdeckungseinrichtung 66 als Schlauch 70 ausgebildet (Figur 2), welcher den Schaltungsträger 18 mit der elektrischen Schaltung 20 umgibt; der Schlauch 70 ist auf den Schaltungsträger 18 aufgezogen. Er überdeckt im Wesentlichen die gesamte Fläche des Schaltungsträgers 18 zwischen dem Sensorelement 26 und dem elektrischen Anschlusselement 30.

Der Schlauch 70 ist dabei insbesondere geschlossen ausgebildet, d. h. er ist aus einem Bandmaterial hergestellt, welches endlos ist.

Der Schlauch 70 ist vorzugsweise so elastisch, dass er über den Schaltungsträger 18 überziehbar ist und nach der Überziehung sich an diesen mit der elektrischen Schaltung 20 anschmiegt. Beispielsweise wird eine Kombination aus Sensorelement 26, Schaltungsträger 18 und elektrischem Anschlusselement 30 hergestellt. Der Schlauch 70 wird dann durch entsprechende Dehnung über das Sensorelement 26 oder über das elektrische Anschlusselement 30 auf den Schaltungsträger 18 aufgezogen. Der Schlauch 70 lässt sich dabei auf einfache Weise auf die Länge des Schaltungsträgers 18 (bezogen auf die Achse 24) ablängen, um den Schaltungsträger 18 mit der elektrischen Schaltung 20 vollständig zu der Formmasse 64 hin abzudecken, wobei die mindestens eine Lage 68 aus komprimierbarem Material 68 einen Kraftpuffer bereitstellt, durch welchen Kräfte, welche durch die Formmasse 64 verursacht sind, von der elektrischen Schaltung 20 abhaltbar sind bzw. zumindest betragsmäßig verringerbar sind.

Dem Schaltungsträger 18 kann eine Isolierungshülle 72 zur elektrischen Isolierung der elektrischen Schaltung 20 zugeordnet sein. Diese Isolierungshülle 72 kann dabei ein von der Abdeckungseinrichtung 66 getrenntes Element sein, welches beispielsweise die Abdeckungseinrichtung 66 umgibt. Beispielsweise ist die Isolierungshülle 72 durch einen Schrumpfschlauch gebildet, welcher auf die Abdeckungseinrichtung 66 aufgezogen ist.

Es ist grundsätzlich auch möglich, dass die Isolierungshülle 72 Bestandteil der Abdeckungseinrichtung 66 ist. Beispielsweise ist die mindestens eine Lage 68 aus komprimierbarem Material auch aus einem Material mit hoher elektrischer Durchschlagsfestigkeit hergestellt.

Es ist auch möglich, dass die Abdeckungseinrichtung 66 eine weitere Lage aus einem Material mit hoher elektrischer Durchschlagsfestigkeit zur Bildung der Isolierungshülle 72 aufweist. In diesem Fall ist die Abdeckungseinrichtung 66 mehrlagig ausgebildet.

Insbesondere ist die Isolierungshülle 72 dann eine äußere Lage, welche von dem Schaltungsträger 18 abgewandt ist und an welcher die Formmasse 64 anliegt.

Es kann auch eine elektrische Abschirmungshülle 74 vorgesehen sein, welche zur Abschirmung der elektrischen Schaltung 20 von elektromagnetischen Wellen dient. Die Abschirmungshülle 74 ist aus einem metallischen Material hergestellt. Beispielsweise ist sie aus einer metallischen Folie hergestellt.

Es ist dabei grundsätzlich möglich, dass die Abschirmungshülle 74 an der Abdeckungseinrichtung 66 angeordnet ist. Zu der elektrischen Schaltung 20 hin ist eine Lage 68 aus komprimierbarem Material vorgesehen, um Kurzschlüsse zu verhindern.

Die Abdeckungseinrichtung 66 ist beispielsweise mehrlagig ausgebildet und umfasst mindestens eine Lage 68 aus komprimierbarem Material, eine integrierte Abschirmungshülle 74 und fakultativ eine elektrische Isolierungshülle 72.

Beispielsweise liegt die Abschirmungshülle 74 zwischen einer ersten Lage aus komprimierbarem Material und einer zweiten Lage aus komprimierbarem Material.

Es ist beispielsweise auch möglich, dass eine Abdeckungseinrichtung an dem Schaltungsträger 18 angeordnet ist, welche um diesen gewickelt ist. Eine solche Abdeckungseinrichtung ist insbesondere aus einem offenen Bandmaterial hergestellt; dieses Bandmaterial ist um den Schaltungsträger 18 gewickelt.

Es ist dabei möglich, dass das Bandmaterial eine Klebeseite aufweist, um dieses adhäsiv an dem Schaltungsträger 18 festzulegen.

Erfindungsgemäß ist an dem Schaltungsträger 18 mit der elektrischen Schaltung 20 eine Abdeckungseinrichtung 66 angeordnet, welche mindestens eine Lage 68 aus komprimierbarem Material wie beispielsweise einem geschlossenporigen Schaummaterial umfasst. Durch die Abdeckungseinrichtung 66 lassen sich durch die Formmasse 64 in Richtung der elektrischen Schaltung 20 wirkende Kräfte von der elektrischen Schaltung 20 abfangen bzw. zumindest betragsmäßig reduzieren. Dadurch wiederum lässt sich die elektrische Schaltung 20 schützen. Es ist dabei grundsätzlich möglich, dass die Abdeckungseinrichtung 66 so angeordnet und ausgebildet ist, dass keinerlei Formmasse zu der elektrischen Schaltung 20 gelangen kann. Es ist beispielsweise auch möglich, dass die Abdeckungseinrichtung 66 so angeordnet und ausgebildet ist, dass eine geringe Menge an Formmasse 64 zu der elektrischen Schaltung 20 gelangen kann. Die Abdeckungseinrichtung 66 ist beispielsweise als einlagiger oder mehrlagiger Schlauch 70 hergestellt oder durch Wicklung eines Bands an dem Schaltungsträger 18 hergestellt. Dadurch lässt sich auf einfache Weise ein elektrisches Gerät 10 mit hoher Zuverlässigkeit bereitstellen, da die durch Befüllung des Gehäuses 12 mit Formmasse 64 während der Herstellung des elektrischen Geräts 10 verursachten Probleme bzw. die Probleme aufgrund unterschiedlicher Wärmeausdehnungen während des Einsatzes des elektrischen Geräts 10 stark verringert sind.

### Das elektrische Gerät 10 wird wie folgt hergestellt:

Die Abdeckungseinrichtung 66 wird aus einem Fertigmaterial (Trockenmaterial) beispielsweise als Schlauch 70 oder als Wicklung an dem Schaltungsträger 18 mit der elektrischen Schaltung 20 angeordnet. Beispielsweise wird der Schlauch 70 über den Schaltungsträger 18 gezogen oder dieser wird entsprechend umwickelt.

Es kann dabei vorgesehen, dass die elektrische Schaltung 20 mit der daran positionierten Abdeckungseinrichtung 66 elektrisch getestet wird. Wenn ein Defekt detektiert wird, dann kann die Abdeckungseinrichtung 66 abgelöst werden und die elektrische Schaltung 20 repariert werden, indem beispielsweise ein oder mehrere defekte Schaltungselemente ausgetauscht werden.

Der Schaltungsträger 18 mit der Abdeckungseinrichtung 66 wird dann in dem Gehäuse 12 positioniert. Der Innenraum 14 wird mit auszuhärtender Formmasse 64 befüllt. Bei einer alternativen Ausführungsform wird der Innenraum 14 mit aushärtbarer Formmasse befüllt, bevor der Schaltungsträger 18 eingeführt wird. Entsprechende Herstellungsverfahren sind in der DE 100 13 218 A1 beschrieben, auf die ausdrücklich Bezug genommen wird.

Beispielsweise wird eine Kombination aus Sensorelement 26, Schaltungsträger 18 und elektrischem Anschlusselement 30 hergestellt, an welchem die Abdeckungseinrichtung 66 positioniert wird. Diese Kombination wird dann in dem Gehäuse 12 positioniert. Dazu wird beispielsweise zuvor der Einsatz 46 von dem vorderen Ende 42 her in das Gehäuse 12 geschoben und in diesem Einsatz wird das Sensorelement 26 positioniert. Anschließend wird der Innenraum 14 mit aushärtbarer Formmasse 64 befüllt und noch vor der Aushärtung wird der Einsatz 52 in das Gehäuse 12 geschoben. Dabei wird das elektrische Anschlusselement 30 mit seinem Halteelement 36 in die Öffnung 58 gebracht und damit für eine automatische Ausrichtung des Schaltungsträgers 18 in dem Gehäuse 12 gesorgt.

Bei einer alternativen Ausführungsform wird nach Einschieben des Einsatzes 46 das Gehäuse zunächst mit aushärtbarer Formmasse 64 befüllt und dann wird die Kombination aus Schaltungsträger 18, Sensorelement 26 und elektrischem Anschlusselement 30 (mit angeordneter Abdeckungseinrichtung 66) in die noch nicht ausgehärtete Formmasse eingeführt, und zwar derart, dass das Sensorelement 26 an einer Innenseite des Deckelbereichs 48 anliegt. Anschließend wird wie oben beschrieben der Einsatz 52 mit seinem Eintauchbereich 54 in das Gehäuse 12 eingetaucht.

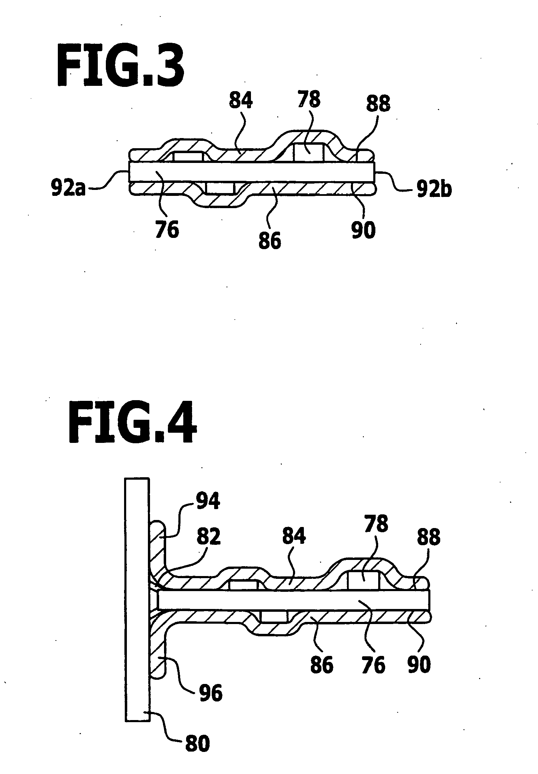

Bei einem weiteren Ausführungsbeispiel, welches in den Figuren 3 und 4 gezeigt ist, ist eine Abdeckungseinrichtung vorgesehen, welche eine oder mehrere Matten umfasst. An einem Schaltungsträger 76, an welchem elektrische Schaltungselemente 78 sitzen, ist beispielsweise an einem vorderen Ende ein Sensorelement 80 angeordnet. Dieses Sensorelement ist über Kontaktstellen 82 elektrisch mit dem Schaltungsträger 76 verbunden. Die Kontaktstellen 82 sind insbesondere Lötstellen, die das Sensorelement 80 auch mechanisch an dem Schaltungsträger 76 fixieren.

Als Abdeckungseinrichtung sind Matten 84, 86 vorgesehen. Diese sind beispielsweise aus einem Schaumstoffmaterial wie oben beschrieben hergestellt.

Die Matte 84 ist an einer Oberseite 88 des Schaltungsträgers 76 mit elektrischen Schaltungselementen 78 angeordnet. Die Matte 86 ist an einer der Oberseite 88 gegenüberliegenden Unterseite 90 angeordnet.

Die Matten 84 und 86 decken die elektrischen Schaltungselemente 78 zu der Formmasse hin wie oben beschrieben ab.

Die Matten 84 und 86 sind an dem Schaltungsträger 76 mit dem elektrischen Schaltungselement 78 beispielsweise adhäsiv fixiert. Insbesondere sind sie so adhäsiv fixiert, dass sie ohne Beschädigung der elektrischen Schaltungselemente 78 und eventueller Kontaktstellen und Verbindungen abnehmbar sind.

Die Matten 84, 86 sind so ausgebildet, dass sie nicht über Seitenflächen 92a, 92b des Schaltungsträgers 76 hinausragen. Die maximale Querbreite der Kombination aus Schaltungsträger 76, elektrischen Schaltungselementen 78 und Matten 84, 86 ist dadurch durch den Schaltungsträger 76 vorgegeben. Die Matten 84, 86 erhöhen also die Querbreite nicht.

Es kann vorgesehen sein, dass die Matten 84, 86 über die Kontaktstellen 82 geführt sind und diese damit gegenüber der Formmasse abdecken.

Insbesondere weisen die Matten 84, 86 einen Querbereich 94, 96 auf, in welchem sie quer zu der jeweiligen Oberseite 88 und Unterseite 90 orientiert sind. Mit den Querbereichen 94, 96 sind die Matten 84, 86 "hochgeschlagen" und liegen an dem Sensorelement 80 an.

Das Sensorelement 80 ist quer zu dem Schaltungsträger 76 orientiert.

Mit den Querbereichen 94, 96 sind die Matten 84, 86 an dem Sensorelement 80 beispielsweise adhäsiv fixiert.

Ein elektrisches Gerät, welches mit dem Schaltungsträger 76 mit den elektrischen Schaltungselementen 78 und der entsprechenden Abdeckungseinrichtung versehen ist, funktioniert wie oben beschrieben und lässt sich auf die beschriebene Weise herstellen.

## Patentansprüche

1. Elektrisches Gerät, umfassend ein Gehäuse (12), mindestens einen Schaltungsträger (18; 76) mit einer elektrischen Schaltung (20), welcher in dem Gehäuse (12) positioniert ist, wobei in einem Innenraum (14) des Gehäuses (12) eine Formmasse (64) angeordnet ist, und eine Abdeckungseinrichtung (66), welche zwischen der elektrischen Schaltung (20) oder einem Teil der elektrischen Schaltung (20) und der Formmasse (64) angeordnet ist und welche aus einem zusammenhängenden Fertigmaterial hergestellt ist und kompressibel ist, und durch welche Kräfte aufnehmbar sind, die in Richtung der elektrischen Schaltung (20) wirken, **dadurch gekennzeichnet, dass** die Abdeckungseinrichtung (66) als Schlauch (70) ausgebildet ist und dass die Abdeckungseinrichtung (66) so elastisch ausgebildet ist, dass sie bei der Herstellung des elektrischen Geräts über den mindestens einen Schaltungsträger (18; 76) mit der elektrischen Schaltung (20) ziehbar ist und an diesem nach dem Überziehen anliegt.

2. Elektrisches Gerät nach Anspruch 1, **dadurch gekennzeichnet, dass** die Abdeckungseinrichtung (66) mindestens an einem Teil der elektrischen Schaltung (20) anliegt.

3. Elektrisches Gerät nach einem der vorangehenden Ansprüche, **dadurch gekennzeichnet, dass** die Abdeckungseinrichtung (66) mindestens an einem Teil des Schaltungsträgers (18; 76) anliegt.

4. Elektrisches Gerät nach einem der vorangehenden Ansprüche, **dadurch gekennzeichnet, dass** die Formmasse (64) an der Abdeckungseinrichtung (66) oder an einer Zwischenlage (72) anliegt, welche selber an der Abdeckungseinrichtung (66) anliegt.

5. Elektrisches Gerät nach einem der vorangehenden Ansprüche, **dadurch gekennzeichnet, dass** die Abdeckungseinrichtung (66) als Ganzes bei der Herstellung des elektrischen Geräts handhabbar ist.

6. Elektrisches Gerät nach einem der vorangehenden Ansprüche, **dadurch gekennzeichnet, dass** die Abdeckungseinrichtung (66) aus einem Bandmaterial hergestellt ist.

7. Elektrisches Gerät nach einem der vorangehenden Ansprüche, **dadurch gekennzeichnet, dass** die Abdeckungseinrichtung (66) oder ein oder mehrere Teile (84; 86) der Abdeckungseinrichtung (66) eine Klebeseite aufweisen.

8. Elektrisches Gerät nach einem der vorangehenden Ansprüche, **dadurch gekennzeichnet, dass** die Abdeckungseinrichtung (66) den mindestens einen Schaltungsträger (18; 76) mit der elektrischen Schaltung (20) im Wesentlichen vollständig zu der Formmasse (64) hin abdeckt.

9. Elektrisches Gerät nach einem der vorangehenden Ansprüche, **dadurch gekennzeichnet, dass** die Abdeckungseinrichtung (66) den mindestens einen Schaltungsträger (18; 76) umgibt.

10. Elektrisches Gerät nach einem der vorangehenden Ansprüche, **dadurch gekennzeichnet, dass** die Abdeckungseinrichtung (66) mindestens teilweise aus einem Schaummaterial hergestellt ist.

11. Elektrisches Gerät nach Anspruch 10, **dadurch gekennzeichnet, dass** das Schaummaterial geschlossenporig ist.

12. Elektrisches Gerät nach Anspruch 10 oder 11, **dadurch gekennzeichnet, dass** das Schaummaterial der elektrischen Schaltung (20) zugewandt ist.

13. Elektrisches Gerät nach einem der Ansprüche 10 bis 12, **dadurch gekennzeichnet, dass** das Schaummaterial eine Dicke von mindestens 0,8 mm im nicht-komprimierten Zustand aufweist.

14. Elektrisches Gerät nach einem der vorangehenden Ansprüche, **dadurch gekennzeichnet, dass** dem mindestens einen Schaltungsträger (18; 76) eine Isolierungshülle (72) zur elektrischen Isolierung zugeordnet ist.

15. Elektrisches Gerät nach Anspruch 14, **dadurch gekennzeichnet, dass** die Isolierungshülle (72) die Abdeckungseinrichtung (66) umgibt.

16. Elektrisches Gerät nach einem der vorangehenden Ansprüche, **dadurch gekennzeichnet, dass** dem mindestens einen Schaltungsträger (18; 76) eine elektrische Abschirmungshülle (74) zugeordnet ist.

17. Elektrisches Gerät nach einem der vorangehenden Ansprüche, **dadurch gekennzeichnet, dass** die Abdeckungseinrichtung (66) mehrlagig ausgebildet ist mit mindestens einer Lage (68) aus einem kompressiblen Material zur Kraftaufnahme.

18. Elektrisches Gerät nach Anspruch 17, **dadurch gekennzeichnet, dass** eine innere Lange, welche der elektrischen Schaltung (20) zugewandt ist, eine Lage aus kompressiblem Material ist.

19. Elektrisches Gerät nach Anspruch 17 oder 18, **dadurch gekennzeichnet, dass** die Abdeckungseinrichtung (66) mindestens eine elektrische Abschirmungslage (74) aufweist.

20. Elektrisches Gerät nach Anspruch 19, **dadurch gekennzeichnet, dass** die elektrische Abschirmungslage (74) zwischen Lagen aus kompressiblem Material anbeordnet ist.

21. Elektrisches Gerät nach einem der Ansprüche 17 bis 20, **dadurch gekennzeichnet, dass** die Abdeckungseinrichtung (66) mindestens eine elektrische Isolierungslage (72) aufweist.

22. Elektrisches Gerät nach einem der vorangehenden Ansprüche, welches ein Sensor ist oder einen Sensor umfasst.

23. Elektrisches Gerät nach Anspruch 22, **dadurch gekennzeichnet, dass** mindestens ein Sensorelement (26; 80) mit dem mindestens einen Schaltungsträger (18; 76) verbunden ist.

24. Elektrisches Gerät nach Anspruch 23, **dadurch gekennzeichnet, dass** das mindestens eine Sensorelement (26; 80) ein induktives Sensorelement oder kapazitives Sensorelement ist.

25. Elektrisches Gerät nach einem der Ansprüche 22 bis 24, **dadurch gekennzeichnet, dass** mindestens ein Sensorelement (26; 80) an einem vorderen Ende (42) des Gehäuses (12) angeordnet ist.

26. Elektrisches Gerät nach einem der vorangehenden Ansprüche, **dadurch gekennzeichnet, dass** ein elektrisches Anschlusselement (30) mit dem mindestens einen Schaltungsträger (18; 76) verbunden ist.

27. Elektrisches Gerät nach einem der vorangehenden Ansprüche, **dadurch gekennzeichnet, dass** ein elektrisches Anschlusselement (30) an einem hinteren Ende (44) des Gehäuses (12) angeordnet ist.

28. Elektrisches Gerät nach einem der vorangehenden Ansprüche, **gekennzeichnet durch** eine Ausbildung als Näherungssensor oder Näherungsschalter oder Positionssensor oder Positionsschalter.

29. Elektrisches Gerät nach einem der vorangehenden Ansprüche, **dadurch gekennzeichnet, dass** der mindestens eine Schaltungsträger (18; 76) eine Platine ist.

30. Verfahren zur Herstellung eines elektrischen Geräts, bei dem mindestens ein Schaltungsträger mit einer elektrischen Schaltung in einem Gehäuse positioniert wird und das Gehäuse mit Formmasse befüllt wird, wobei an dem mindestens einen Schaltungsträger eine Abdeckungseinrichtung aus einem Fertigmaterial positioniert wird, welche kompressibel ist und durch welche Kräfte aufnehmbar sind, die in Richtung der elektrischen Schaltung wirken, **dadurch gekennzeichnet, dass** die Abdeckungseinrichtung als Schlauch über den mindestens einen Schaltungsträger gezogen wird.

31. Verfahren nach Anspruch 30, **dadurch gekennzeichnet, dass** die Abdeckungsenrichtung vor Positionierung des mindestens einen Schaltungsträgers in dem Gehäuse an diesem angeordnet wird.

32. Verfahren nach Anspruch 30 oder 31, **dadurch gekennzeichnet, dass** der Schaltungsträger mit positionierter Abdeckungseinrichtung getestet wird.

## Claims

1. Electrical device, comprising a housing (12), at least one circuit carrier (18; 76) with an electric circuit (20), which is positioned in the housing (12), a moulding material (64) being arranged in an interior (14) of the housing (12), and a covering device (66), which is arranged between the electric circuit (20) or a part of the electric circuit (20) and the moulding material (64), and which is made from a cohesive finished material and is compressible, and by means of which forces are absorbable, which act in the direction of the electric circuit (20), **characterized in that** the covering device (66) is configured as a tube (70), and **in that** the covering device (66) is of such elastic construction that during the manufacture of the electrical device it can be pulled over the at least one circuit carrier (18; 76) with the electric circuit (20) and after being pulled over lies against the circuit carrier.

2. Electrical device in accordance with claim 1, **characterized in that** the covering device (66) lies against at least a part of the electric circuit (20).

3. Electrical device in accordance with any one of the preceding claims, **characterized in that** the covering device (66) lies against at least a part of the circuit carrier (18; 76).

4. Electrical device in accordance with any one of the preceding claims, **characterized in that** the moulding material (64) lies against the covering device (66) or against an intermediate layer (72) which itself lies against the covering device (66).

5. Electrical device in accordance with any one of the preceding claims, **characterized in that** the covering device (66) can be handled as a whole during the manufacture of the electrical device.

6. Electrical device in accordance with any one of the preceding claims, **characterized in that** the covering device (66) is made from a band material.

7. Electrical device in accordance with any one of the preceding claims, **characterized in that** the covering device (66) or one or more parts (84; 86) of the covering device (66) have an adhesive side.

8. Electrical device in accordance with any one of the preceding claims, **characterized in that** the covering device (66) covers the at least one circuit carrier (18; 76) with the electric circuit (20) substantially completely towards the moulding material (64).

9. Electrical device in accordance with any one of the preceding claims, **characterized in that** the covering device (66) surrounds the at least one circuit carrier (18; 76).

10. Electrical device in accordance with any one of the preceding claims, **characterized in that** the covering device (66) is made at least partially from a foam material.

11. Electrical device in accordance with claim 10, **characterized in that** the foam material has closed pores.

12. Electrical device in accordance with claim 10 or 11, **characterized in that** the foam material faces the electric circuit (20).

13. Electrical device in accordance with any one of claims 10 to 12, **characterized in that** the foam material has a thickness of at least 0.8 mm in the uncompressed state.

14. Electrical device in accordance with any one of the preceding claims, **characterized in that** an insulating sheath (72) for electrical insulation is associated with the at least one circuit carrier (18; 76).

15. Electrical device in accordance with claim 14, **characterized in that** the insulating sheath (72) surrounds the covering device (66).

16. Electrical device in accordance with any one of the preceding claims, **characterized in that** an electric shielding sheath (74) is associated with the at least one circuit carrier (18; 76).

17. Electrical device in accordance with any one of the preceding claims, **characterized in that** the covering device (66) is of multilayered construction with at least one layer (68) made of a compressible material for the absorption of forces.

18. Electrical device in accordance with claim 17, **characterized in that** an inner layer, which faces the electric circuit (20), is a layer made of compressible material.

19. Electrical device in accordance with claim 17 or 18, **characterized in that** the covering device (66) has at least one electric shielding layer (74).

20. Electrical device in accordance with claim 19, **characterized in that** the electric shielding layer (74) is arranged between layers made of compressible material.

21. Electrical device in accordance with any one of claims 17 to 20, **characterized in that** the covering device (66) comprises at least one electric insulating layer (72).

22. Electrical device in accordance with any one of the preceding claims, which is a sensor or comprises a sensor.

23. Electrical device in accordance with claim 22, **characterized in that** at least one sensor element (26; 80) is connected to the at least one circuit carrier (18; 76).

24. Electrical device in accordance with claim 23, **characterized in that** the at least one sensor element (26; 80) is an inductive sensor element or a capacitive sensor element.

25. Electrical device in accordance with any one of claims 22 to 24, **characterized in that** at least one sensor element (26; 80) is arranged at a front end (42) of the housing (12).

26. Electrical device in accordance with any one of the preceding claims, **characterized in that** an electric connection element (30) is connected to the at least one circuit carrier (18; 76).

27. Electrical device in accordance with any one of the preceding claims, **characterized in that** an electric connection element (30) is arranged at a rear end (44) of the housing (12).

28. Electrical device in accordance with any one of the preceding claims, **characterized by** a configuration as proximity sensor or proximity switch or position sensor or position switch.

29. Electrical device in accordance with any one of the preceding claims, **characterized in that** the at least one circuit carrier (18; 76) is a circuit board.

30. Method of manufacturing an electrical device wherein at least one circuit carrier with an electric circuit is positioned in a housing and the housing is filled with moulding material, and wherein a covering device made of a finished material, which is compressible and by means of which forces acting in the direction of the electric circuit are absorbable, is positioned at the at least one circuit carrier, **characterized in that** the covering device is pulled as a tube over the at least one circuit carrier.

31. Method in accordance with claim 30, **characterized in that** before positioning the at least one circuit carrier in the housing, the covering device is arranged thereon.

32. Method in accordance with claim 30 or 31, **characterized in that** the circuit carrier is tested with the positioned covering device.

## Revendications

1. Appareil électrique, comprenant un boîtier (12), au moins un support de circuit (18 ; 76) avec un circuit électrique (20), lequel est positionné dans le boîtier (12), une matière à mouler (64) étant disposée dans un espace intérieur (14) du boîtier (12), ainsi qu'un dispositif de recouvrement (66), lequel est disposé entre le circuit électrique (20) ou une partie du circuit électrique (20) et la matière à mouler (64) et lequel se compose d'une matière finie intégrée et qui est compressible, et grâce auquel des forces peuvent être réceptionnées, lesquelles agissent en direction du circuit électrique (20), **caractérisé en ce que** le dispositif de recouvrement (66) est réalisé en tant que tuyau (70), et **en ce que** le dispositif de recouvrement (66) est réalisé de manière si élastique qu'il est possible de l'étirer par-dessus le support de circuit (18 ; 76) au moins au nombre de un avec le circuit électrique (20) lors de la fabrication de l'appareil électrique, et qu'il adhère ensuite uniformément sur celui-ci après avoir été étiré par-dessus.

2. Appareil électrique selon la revendication 1, **caractérisé en ce que** le dispositif de recouvrement (66) adhère uniformément au moins sur une partie du circuit électrique (20).

3. Appareil électrique selon l'une quelconque des revendications précédentes, **caractérisé en ce que** le dispositif de recouvrement (66) adhère uniformément au moins sur une partie du support de circuit (18 ; 76).

4. Appareil électrique selon l'une quelconque des revendications précédentes, **caractérisé en ce que** la matière à mouler (64) adhère uniformément sur le dispositif de recouvrement (66) ou sur une couche intermédiaire (72), laquelle adhère quant à elle uniformément sur le dispositif de recouvrement (66).

5. Appareil électrique selon l'une des revendications précédentes, **caractérisé en ce que** le dispositif de recouvrement (66) peut être manié en tant que tout lors de la fabrication de l'appareil électrique.

6. Appareil électrique selon l'une quelconque des revendications précédentes, **caractérisé en ce que** le dispositif de recouvrement (66) est fabriqué en une matière en bande.

7. Appareil électrique selon l'une quelconque des revendications précédentes, **caractérisé en ce que** le dispositif de recouvrement (66), ou une ou plusieurs parties (84 ; 86) du dispositif de recouvrement (66), présentent un côté adhésif.

8. Appareil électrique selon l'une quelconque des revendications précédentes, **caractérisé en ce que** le dispositif de recouvrement (66) recouvre le support de circuit (18 ; 76) au moins au nombre de un avec le circuit électrique (20), essentiellement complètement en direction de la matière à mouler (64).

9. Appareil électrique selon l'une quelconque des revendications précédentes, **caractérisé en ce que** le dispositif de recouvrement (66) entoure le support de circuit (18 ; 76) au moins au nombre de un.

10. Appareil électrique selon l'une quelconque des revendications précédentes, **caractérisé en ce que** le dispositif de recouvrement (66) est fabriqué au moins partiellement à partir d'un matériau en mousse.

11. Appareil électrique selon la revendication 10, **caractérisé en ce que** le matériau en mousse est à pores fermés.

12. Appareil électrique selon la revendication 10 ou 11, **caractérisé en ce que** le matériau en mousse est tourné vers le circuit électrique (20).

13. Appareil électrique selon l'une quelconque des revendications 10 à 12, **caractérisé en ce que** le matériau en mousse présente une épaisseur d'au moins 0,8 mm à l'état non comprimé.

14. Appareil électrique selon l'une quelconque des revendications précédentes, **caractérisé en ce que** l'on associe au support de circuit (18 ; 76) au moins au nombre de un une enveloppe isolante (72) pour l'isolation électrique.

15. Appareil électrique selon la revendication 14, **caractérisé en ce que** l'enveloppe isolante (72) entoure le dispositif de recouvrement (66).

16. Appareil électrique selon l'une quelconque des revendications précédentes, **caractérisé en ce que** l'on associe au support de circuit (18 ; 76) au moins au nombre de un une enveloppe de blindage électrique (74).

17. Appareil électrique selon l'une quelconque des revendications précédentes, **caractérisé en ce que** le dispositif de recouvrement (66) est réalisé de manière à être multicouches avec au moins une couche (68) en un matériau compressible pour réceptionner des forces.

18. Appareil électrique selon la revendication 17, **caractérisé en ce qu'**une couche intérieure, laquelle est tournée vers le circuit électrique (20), est une couche en un matériau compressible.

19. Appareil électrique selon la revendication 17 ou 18, **caractérisé en ce que** le dispositif de recouvrement (66) présente au moins une couche de blindage électrique (74).

20. Appareil électrique selon la revendication 19, **caractérisé en ce que** la couche de blindage électrique (74) est disposée entre des couches en matériau compressible.

21. Appareil électrique selon l'une quelconque des revendications 17 à 20, **caractérisé en ce que** le dispositif de recouvrement (66) présente au moins une couche d'isolation électrique (72).

22. Appareil électrique selon l'une quelconque des revendications précédentes, lequel est un détecteur ou bien comprend un détecteur.

23. Appareil électrique selon la revendication 22, **caractérisé en ce qu'**au moins un élément de détection (26 ; 80) est relié au support de circuit (18 ; 76) au moins au nombre de un.

24. Appareil électrique selon la revendication 23, **caractérisé en ce que** l'élément de détection (26 ; 80) au moins au nombre de un est un élément de détection inductif ou un élément de détection capacitif.

25. Appareil électrique selon l'une quelconque des revendications 22 à 24, **caractérisé en ce qu'**au moins un élément de détection (26 ; 80) est disposé sur une extrémité avant (42) du boîtier (12).

26. Appareil électrique selon l'une quelconque des revendications précédentes, **caractérisé en ce qu'**un élément de connexion électrique (30) est relié au support de circuit (18 ; 76) au moins au nombre de un.

27. Appareil électrique selon l'une quelconque des revendications précédentes, **caractérisé en ce qu'**un élément de connexion électrique (30) est disposé sur une extrémité arrière (44) du boîtier (12).

28. Appareil électrique selon l'une quelconque des revendications précédentes, **caractérisé par** une réalisation en tant que détecteur de proximité ou interrupteur de proximité ou détecteur de position ou interrupteur de position.

29. Appareil électrique selon l'une quelconque des revendications précédentes, **caractérisé en ce que** le support de circuit (18 ; 76) au moins au nombre de un est une platine.

30. Procédé de fabrication d'un appareil électrique, dans le cadre duquel au moins un support de circuit avec un circuit électrique est positionné dans un boîtier et le boîtier étant rempli d'une matière à mouler, moyennant quoi, sur ce support de circuit au moins au nombre de un, un dispositif de recouvrement en un matériau fini est positionné, lequel est compressible et grâce auquel des forces peuvent être réceptionnées, lesquelles agissent en direction du circuit électrique, **caractérisé en ce que** le dispositif de recouvrement est tiré en tant que tuyau par-dessus le support de circuit au moins au nombre de un.

31. Procédé selon la revendication 30, **caractérisé en ce que** le dispositif de recouvrement, avant le positionnement du support de circuit au moins au nombre de un, est disposé sur celui-ci à l'intérieur du boîtier.

32. Procédé selon la revendication 30 ou 31, **caractérisé en ce que** le support de circuit est testé avec le dispositif de recouvrement positionné.
